# EUROPEAN PATENT APPLICATION

(11) **EP 4 752 628 A1**
(43) Date of publication of application: **03.06.2026**
(21) Application number: 24215671.9
(22) Date of filing: 27.11.2024
(51) Int. Cl.: G03F 7/00, G03F 9/00

(54) **SENSOR SYSTEM AND METHOD FOR ALIGNMENT**

(71) Applicant: ASML Netherlands B.V., 5500 AH Veldhoven (NL)
(72) Inventor: REIJNDERS, Marinus, Petrus, 5500 AH Veldhoven (NL); CARBONE, Ludovico, 5500 AH Veldhoven (NL); DREISSEN, Mante, 5500 AH Veldhoven (NL)
(74) Representative: ASML Netherlands B.V.

(57) **Abstract**

The present disclosure provides a sensor system, comprising: a first sensor for determining a position of an aerial image as formed by a projection system, the first sensor comprising at least one first grating (66), and a detector (64) configured to record first radiation (82) transmitted through the first grating (66); and a second sensor (AS) for detecting second radiation (94) as reflected from the at least one first grating (66).

## Description

### FIELD

The present invention relates to a sensor system and to a method for alignment. The sensor system may be included in a lithographic apparatus, for instance for measuring position or alignment of an image or a piece of equipment such as a wafer stage.

### BACKGROUND

Light generated by means of a radiation source can be used by exposure apparatuses for semiconductor manufacturing processes. Examples of such exposure apparatuses are a lithographic apparatus, a metrology, or an inspection apparatus, more specifically a mask inspection apparatus and even more specifically an actinic mask inspection apparatus.

A lithographic apparatus is a machine constructed to apply a desired pattern onto a substrate. A lithographic apparatus can be used, for example, in the manufacture of integrated circuits (ICs). A lithographic apparatus may, for example, project a pattern at a patterning device (e.g., a mask) onto a layer of radiation-sensitive material (e.g., a photoresist or resist) provided on a substrate. To project a pattern on a substrate a lithographic apparatus may use electromagnetic radiation. The wavelength of this radiation determines the minimum size of features which can be formed on the substrate. A lithographic apparatus, which uses EUV radiation, having a wavelength within the range 4-20 nm, for example 6.7 nm or 13.5 nm, may be used to form smaller features on a substrate than a lithographic apparatus which uses, for example, radiation with a wavelength of 193 nm.

An (actinic) mask inspection apparatus is an apparatus that is configured for measuring dimensions or detecting defects in masks or mask blanks. EUV lithography uses a reflective surfaces instead of a lenses as optics. Mask blanks used in EUV lithography generally have a multilayer structure which functions as a Bragg reflector, the multilayers may be alternatingly Molybdenum and Silicon. If a defect exists in this structure, the projected pattern will be deformed in the lithographic process. Therefore, mask inspection to check whether a defect is present is considered a requirement for a mass-production process. EUV mask inspection may be used for several purposes and in several different stages. Firstly, it can be used for the detection of phase defects that may occur in mask blanks. Such phase defects may occur during the manufacturing of the multilayer stack of the mask blank. If undetected, these phase defects are printed on all chips printed with the part of a mask containing the phase defects. Such phase defects may be correctly detected by using the same or similar (13.5nm) actinic EUV wavelength as the lithography tool. Secondly, mask inspection can be used for patterned mask inspection and can be carried out for the quality control of EUV patterned masks. For example, the mask inspection can be used to measure critical dimensions on the mask blank. In addition to phase defects, absorber pattern defects on the surface can be detected. Thirdly, mask inspection can be used for simulating exposure and determining the deterioration of optical contrast of a defect detected in the actinic inspection. Forth, the mask inspection can be used for optical proximity correction (OPC) evaluation or during mask repair process so as to improve pattern transfer fidelity. Further, it can be used for inspecting optical contrast after fixing the defect. In addition to the above, mask inspection can also be used to measure small particle/amplitude effects.

Lithographic machines in general typically use a number of sensors to align substrates and to focus the radiated pattern onto the substrate. For instance, a transmission image sensor (TIS) located at or near the wafer stage may determine the position of an aerial image of a grating at reticle level as formed by the projection system.

The TIS typically comprises a sensor and a detector grating. The position of the reticle level grating relative to the detector grating can be determined using the sensor, which functions as the detector and is typically arranged underneath the detector grating.

The TIS also comprises other components, such as one or more alignment markers. The position of the alignment marker can be determined using an alignment sensor. The alignment sensor may function to determine the position of the substrate stage, on which the TIS is located. The sensor for instance measures the position of a TIS plate (which typically carries marks for this measurement and detectors for finding the aerial image). The sensor typically also includes one or more markers for an alignment sensor, which also measures marks on the substrate. So, marks on the substrate, marks on the transmission image sensor, and the aerial image are related. Assuming that the distance between the detector grating and the alignment marker is known, the position of the aerial image relative to the wafer stage can be determined. These sensor measurements are typically used during alignment of the substrate stage, which are required to position and focus the object stage carrying a substate with respect to the projected pattern.

However, due to deformation of the sensor, the distance between the detector grating and the alignment marker may vary over time or is inaccurate to a certain extent. A difference between the assumed distance between the detector grating and the alignment marker, and the actual distance, may typically result in an overlay error. An overlay error herein typically refers to a misalignment of consecutive layers as deposited in a lithographic process.

It is an aim to provide an improved system, obviating at least one or more disadvantages of the prior art.

### SUMMARY

The present disclosure provides a sensor system, comprising:
- a first sensor for determining a position of an aerial image as formed by a projection system, the first sensor comprising at least one first grating, and a detector configured to record first radiation transmitted through the first grating; and
- a second sensor for detecting second radiation as reflected from the at least one first grating.

In an embodiment, the first grating is configured as a reference marker for the second sensor.

In an embodiment, the second sensor is an alignment sensor.

In an embodiment, the first sensor is an image sensor.

In an embodiment, the at least one first grating comprises a first array of lines allowing at least part of the first radiation to pass through.

In an embodiment, the at least one first grating comprises a second array of lines configured to substantially absorb the first radiation, the second array of lines being interleaved with the first array of lines.

In an embodiment, the system comprises a third array of lines, configured to substantially reflect the second radiation towards the second sensor, the third array of lines being interleaved with the first array of lines.

In an embodiment, the third array of lines comprises a top layer comprised of a material which is substantially reflective for the second radiation.

In an embodiment, the material comprises one or more of aluminum, silver, copper, or gold.

In an embodiment, the first radiation is in the EUV spectrum.

In an embodiment, the second radiation includes radiation in one of more of the ultraviolet spectrum, the visible light spectrum, or the infrared spectrum.

According to another aspect, the disclosure provides an object stage comprising a sensor system, the sensor system comprising: - a first sensor for determining a position of an aerial image as formed by a projection system, the first sensor comprising at least one first grating, and a detector configured to record first radiation transmitted through the first grating, the at least one first grating being adapted for reflecting second radiation towards a second sensor.

According to another aspect, the disclosure provides a lithographic apparatus comprising:
an object stage, comprising a sensor system, the sensor system comprising: - a first sensor for determining a position of an aerial image as formed by a projection system, the first sensor comprising at least one first grating, and a detector configured to record first radiation transmitted through the first grating, the at least one first grating being adapted for reflecting second radiation towards a second sensor.

In an embodiment, the lithographic apparatus comprises a source of the second radiation.

In an embodiment, the sensor system comprises a third sensor, for detecting third radiation as reflected from the at least one first grating.

In an embodiment, the lithographic apparatus comprises a source of the first radiation for exposure of a pattern on a substrate, the first radiation being in the extreme ultraviolet (EUV) spectrum.

According to yet another aspect, the disclosure provides a method of image alignment, the method comprising the steps of:
- projecting an aerial image onto a sensor system using first radiation;
- using a first sensor for determining a position of the aerial image, the first sensor comprising at least one first grating and a detector configured to record the first radiation as transmitted through the first grating;
- projecting second radiation onto the first grating; and
- using a second sensor for detecting the second radiation as reflected from the at least one first grating.

In an embodiment, the step of using the second sensor for detecting the second radiation as reflected from the at least one first grating includes alignment of an object with respect to a reference position.

The system, method and object table of the present disclosure enable to more accurately measure the position of a substrate, while obviating drift and the resulting overlay errors. By obviating drift, the system and method avoid machine downtime, and increase productivity, accuracy, and yield.

### BRIEF DESCRIPTION OF THE DRAWINGS

Embodiments of the invention will now be described, by way of example only, with reference to the accompanying schematic drawings, in which:
- Figure 1 shows a schematical representation of a lithographic system comprising a lithographic apparatus and a radiation source;
- Figure 2 shows a schematical representation of a system for (actinic) mask inspection;
- Figure 3 shows a schematical representation of an alternative radiation source;
- Figure 4A shows a side view of a measurement side of a lithographic apparatus;
- Figure 4B shows a side view of an expose side of a lithographic apparatus;
- Figure 5 shows a perspective view of an exemplary method for scanning an image align sensor;
- Figure 6 shows a top view of an exemplary sensor comprising two separate marker gratings;
- Figure 7 shows a top view of an embodiment of a marker of the present disclosure;
- Figure 8 shows a top view of an embodiment of a marker of the present disclosure;
- Figure 9 shows a schematic side view in cross section of an embodiment of a grating according to the present disclosure; and
- Figures 10A and 10B show a schematic side view in cross section of an embodiment of a grating according to the present disclosure.

### DETAILED DESCRIPTION

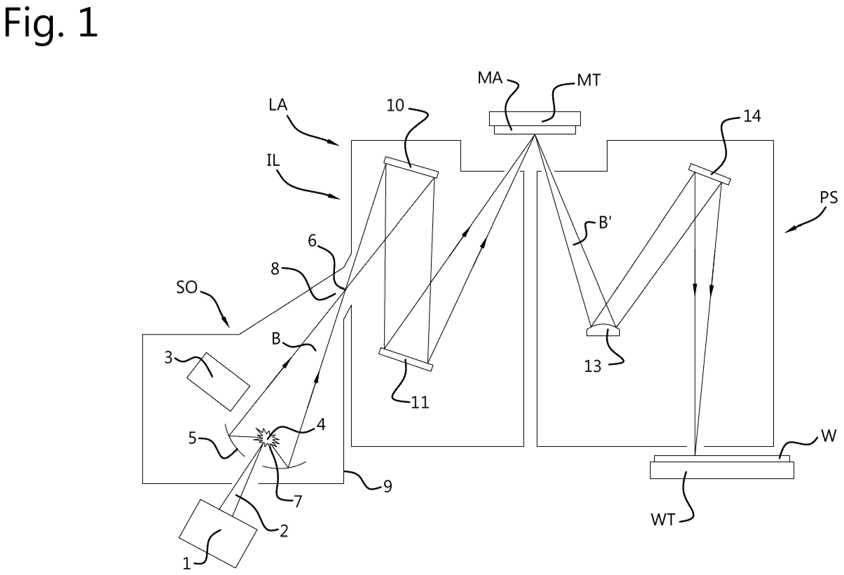

Figure 1 shows a lithographic system comprising a radiation source SO and a lithographic apparatus LA. The radiation source SO is configured to generate an EUV radiation beam B and to supply the EUV radiation beam B to the lithographic apparatus LA. The lithographic apparatus LA comprises an illumination system IL, a support structure MT configured to support a patterning device MA (e.g., a mask), a projection system PS and a substrate table WT configured to support a substrate W.

The illumination system IL is configured to condition the EUV radiation beam B before the EUV radiation beam B is incident upon the patterning device MA. Thereto, the illumination system IL may include a facetted field mirror device 10 and a facetted pupil mirror device 11. The faceted field mirror device 10 and faceted pupil mirror device 11 together provide the EUV radiation beam B with a desired cross-sectional shape and a desired intensity distribution. The illumination system IL may include other mirrors or devices in addition to, or instead of, the faceted field mirror device 10 and faceted pupil mirror device 11.

After being thus conditioned, the EUV radiation beam B interacts with the patterning device MA. As a result of this interaction, a patterned EUV radiation beam B' is generated. The projection system PS is configured to project the patterned EUV radiation beam B' onto the substrate W. For that purpose, the projection system PS may comprise a plurality of mirrors 13,14 which are configured to project the patterned EUV radiation beam B' onto the substrate W held by the substrate table WT. The projection system PS may apply a reduction factor to the patterned EUV radiation beam B', thus forming an image with features that are smaller than corresponding features on the patterning device MA. For example, a reduction factor of 4 or 8 may be applied. Although the projection system PS is illustrated as having only two mirrors 13,14 in Figure 1, the projection system PS may include a different number of mirrors (e.g., six or eight mirrors).

The substrate W may include previously formed patterns. Where this is the case, the lithographic apparatus LA aligns the image, formed by the patterned EUV radiation beam B', with a pattern previously formed on the substrate W.

A relative vacuum, i.e. a small amount of gas (e.g. hydrogen) at a pressure well below atmospheric pressure, may be provided in the radiation source SO, in the illumination system IL, and/or in the projection system PS.

The lithographic apparatus LA and radiation source SO described herein can be used in method for performing a circuit layout patterning process. A circuit layout patterning method comprises receiving a substrate with a photoresist layer. The method further comprises directing EUV radiation from radiation source to the photoresist layer to form a patterned photoresist layer. The method further comprises developing and etching the patterned photoresist layer to form a circuit layout.

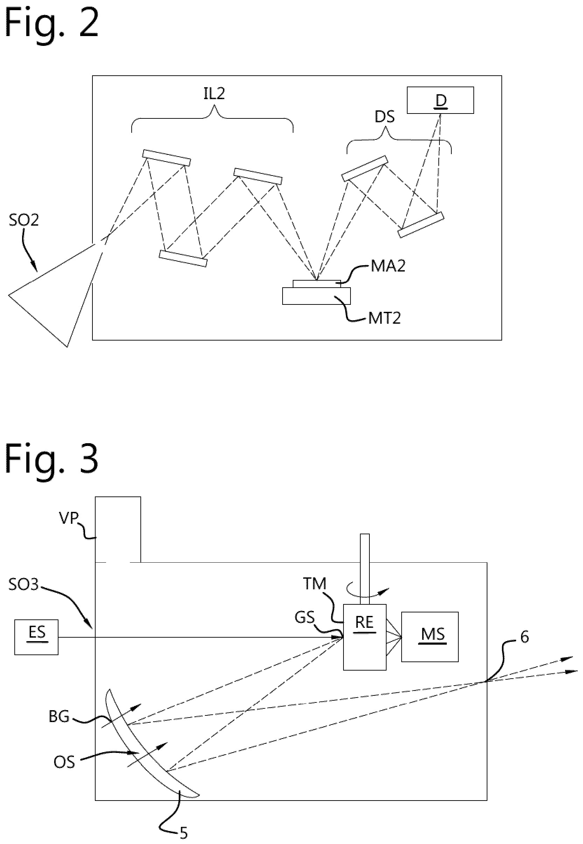

Figure 2 depicts a system for (actinic) mask inspection. A mask inspection system can be used to identify or inspect defects in a mask to be used in a lithographic process by means of an apparatus described in figure 1. The mask inspection system comprises a radiation source SO2 and an illumination system IL2 and a detection system DS. A mask MA2 is placed on a mask stage MT2 and illuminated by the illumination system IL2 reflecting radiation incident from the radiation source SO2. The radiation coming from the illuminated mask is reflected by the detection system DS. In this way an image is formed on a detector D.

The radiation source SO shown in Figure 1 is, for example, of a type which may be referred to as a laser produced plasma (LPP) source. A laser system 1, which may, for example, include a CO2¬ laser, is arranged to deposit energy via a laser beam 2 into a fuel (i.e., a target material), such as tin (Sn) which is provided from, e.g., a fuel generator 3. Although tin is referred to in the following description, any suitable fuel may be used. The fuel may, for example, be in liquid form, and may, for example, be a metal or alloy. The fuel generator 3 may comprise a nozzle configured to direct the fuel, e.g. in the form of droplets, along a trajectory towards a plasma formation region 4. The laser beam 2 is incident upon the fuel at the plasma formation region 4. The deposition of laser energy into the tin creates a plasma 7 at the plasma formation region 4. Radiation, including EUV radiation, is emitted from the plasma 7 during de-excitation and recombination of electrons with ions of the plasma 7.

The EUV radiation from the plasma 7 is collected and focused by a collector 5. Collector 5 comprises, for example, a near-normal incidence radiation collector 5 (sometimes referred to more generally as a normal-incidence radiation collector). The collector 5 may have a multilayer mirror structure which is arranged to reflect EUV radiation (e.g., EUV radiation having a desired wavelength such as 13.5 nm). The collector 5 may have an ellipsoidal configuration, having two focal points. A first one of the focal points may be at the plasma formation region 4, and a second one of the focal points may be at an intermediate focus 6, as discussed below.

The laser system 1 may be spatially separated from the radiation source SO. Where this is the case, the laser beam 2 may be passed from the laser system 1 to the radiation source SO with the aid of a beam delivery system (not shown) comprising, for example, suitable directing mirrors and/or a beam expander, and/or other optics. The laser system 1, the radiation source SO and the beam delivery system may together be considered to be a radiation system.

Radiation that is reflected by the collector 5 forms the EUV radiation beam B. The EUV radiation beam B is focused at intermediate focus 6 to form an image at the intermediate focus 6 of the plasma present at the plasma formation region 4. The image at the intermediate focus 6 acts as a virtual radiation source for the illumination system IL. The radiation source SO is arranged such that the intermediate focus 6 is located at or near to an opening 8 in an enclosing structure 9 of the radiation source SO.

Although Figure 1 depicts the radiation source SO as a laser produced plasma (LPP) source, any suitable source such as a free electron laser (FEL) or a discharge produced plasma (DPP) source may be used to generate EUV radiation.

Figure 3 depicts an alternative radiation source SO3. For generating plasma target material TM, like tin or xenon may be provided to a rotating element RE, like for example rotating wheels, cylinder, or a drum or variations thereof. Target material may be provided in liquified form to the one or more rotating elements, e.g. by means of a target material bath. Alternatively, target material may also be provided in solid or frozen form (e.g. Xenon). Gaseous target material may be sprayed onto the rotating element to replace target material transformed to plasma. According to embodiments the rotating element would be cold enough to solidify the target material. An excitation device ES may be used to assist in plasma formation. According to embodiments this excitation device is a laser, like a solid-state or gas laser. Reflective optics OS, like one or more mirrors, can be used to reflect the EUV light generated to the intermediate focus 6. According to embodiments, the reflective optics comprise a collector mirror. Buffer gas flow BG may be provided to mitigate debris present in the radiation source. Also a vacuum pump VP may be provided to remove gas from the radiation source SO3.

The lithographic process typically includes arranging a photoresist (also referred to as resist) on a substrate, and irradiating the resist with a patterned beam. The resist is a light-sensitive material used in several processes, such as photolithography, to form a patterned coating on a surface of a substrate. The process begins by coating the substrate with the light-sensitive material, typically an organic material. As described with reference to Fig. 1, a patterned mask MA is then applied to the surface to block light, so that only unmasked regions of the material will be exposed to radiation. A solvent, called a developer, is then applied to the surface. In the case of a positive photoresist, the photo-sensitive material is degraded by light and the developer will dissolve away the regions that were exposed to light, leaving behind a coating where the mask was placed. In the case of a negative photoresist, the photosensitive material is strengthened (either polymerized or cross-linked) by radiation, and the developer will dissolve away only the regions that were not exposed to light, leaving behind a coating in areas where the mask was not placed.

Examples of photoresist include, but are not limited to, methyl methacrylate monomers, polymethyl methacrylate (PMMA), acrylate monomer, a mixture of diazonaphthoquinone (DNQ) and novolac resin (a phenol formaldehyde resin) commonly referred to as DNQ-Novolac photoresist, and epoxy-based polymer. Alternatives include metal oxide resists, for example including tin clusters of the type [(RSn)12O4(OH)6]X2.

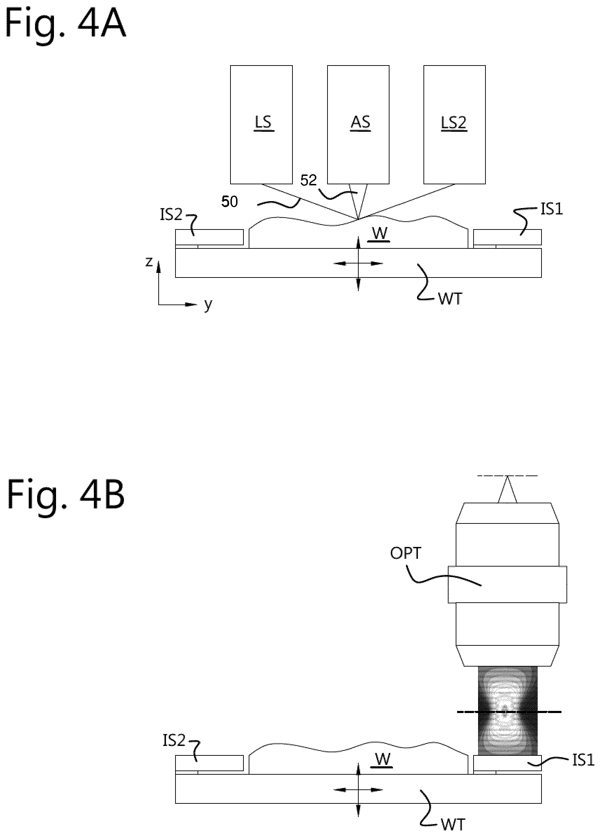

Referring to Figures 4A and 4B, the lithographic apparatus may include an object stage including one or more movable object tables WT. The object table WT is typically movable with respect to a base (not shown). In operation, the object table WT may be provided with a substrate W. Then, the object table WT first moves towards a measurement location or measurement side, exemplified in Figure 4A. Thereafter, the object tables moves to the expose side, see Figure 4B.

Although Figures 4A and 4B are shown as separate figures, please note that the measurement side (Fig. 4A) and the expose aside (Fig. 4B) may typically be located on opposite sides of the same base, with one or more substrate tables being able to move from side to side. The combination of expose side and measurement side may be referred to as the wafer stage or object stage.

For technical details of an object stage comprising multiple object tables, and the functionality thereof including measurement and exposure, reference is made to, for instance, patent US-6597433.

The object table is typically provided with one or more first sensors. The first sensors are image align sensors, such as a first image align sensor IS1 and a second image align sensor IS2. The first sensors are typically arranged relatively near to, or adjacent to, the intended position of the substrate W.

The measurement side of the object stage, see Fig. 4A, is typically provided with a number of other sensors. The measurement side may be provided with one or more of a second sensor and a third sensor. The second sensor may comprise an alignment sensor AS. The third sensor may comprise a level sensor LS. The level sensor LS, which also comprises a second part or detector part LS2, is adapted to measure height or topography of the object W on the object table. The alignment sensor AS may measure the alignment, for instance one or more of the horizontal position in one or both of the x-direction and y-direction, and rotation about the z-axis (Rz). The level sensor may measure height z and one or more of rotations Rx and Ry of the object W with respect to a predetermined setpoint position.

The alignment sensor AS may include a light source. The light source may be a source of second radiation 52, for instance visible light. The visible light herein may have a wavelength in the spectrum of about 380 to about 750 nanometers. Alternatively or in addition, the second sensor may use second radiation in the ultraviolet spectrum or the infrared spectrum. In use, an alignment mark on the object W is irradiated, for instance using the visible light. The reflected light is captured to assess a position of the mark.

The level sensor comprises a first part LS and a second part LS2. The first part may comprise a source of third radiation 50. The third radiation may be any suitable radiation for scanning the top surface of the substrate W. In use, the first level sensor part LS directs the third radiation 50 at the top surface of the substrate W. Herein, the top surface is the surface of the substrate W facing the level sensor and the alignment sensor, and facing away from the object table WT. The level sensor may be adapted to scan the third radiation across the surface of the substrate, in a predetermined pattern. The second level sensor part LS2 may detect the third radiation as it is reflected from the top surface, and use the detected reflection to determine the topology or height map of the top surface of the substrate W.

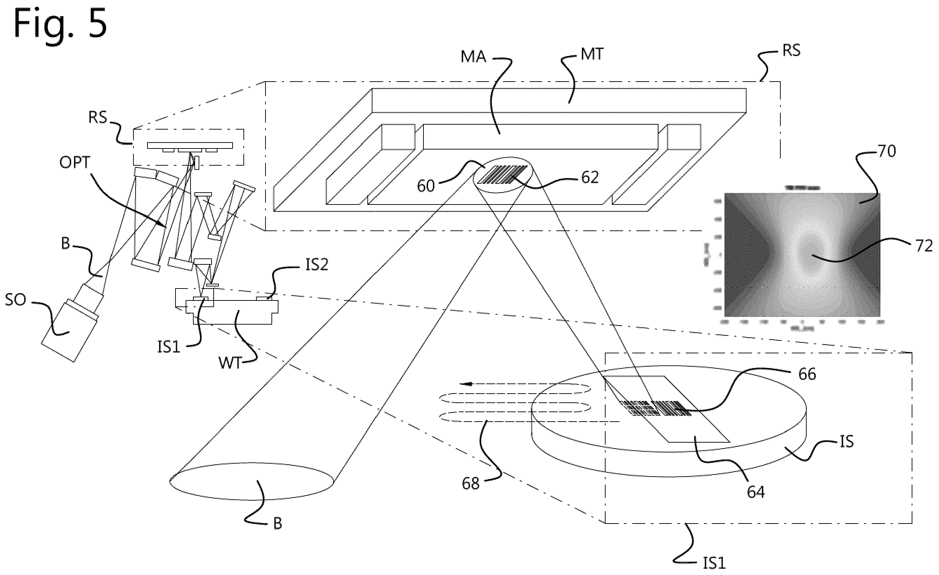

Figure 5 schematically depicts the general working principle of the one or more image align sensors IS. Herein, a reference image 60 is irradiated. Herein, for instance, the aerial image is formed by reflection on the reference image at reticle level, such as grating marks 62 or a mask pattern on or near the mask MA or one of its related components. The reflection creates an image at substrate or wafer level. The aerial image is the light distribution at substrate or wafer level created by the optics, by imaging of the light reflected from the mask pattern or the grating marks 62. Herein, the mask MA may be referred to as a reticle, typically for lithography based on EUV light. The functional stage comprising the reticle and its related object table MT may be referred to as the reticle stage RS.

The image is projected via the optics OPT of the lithographic apparatus onto the object stage. Herein, at least one of the image align sensors IS is positioned at the receiving end of the projection optics OPT. The reference image 60 is projected on the image align sensor IS, forming the aerial image. The image align sensor comprises a photodetector 64 for detecting the projected image. The photodetector is provided with photodetector gratings 66.

The first sensor IS is moved across the beam of radiation from reticle to wafer, for instance in a zigzag pattern 68. The pattern 68 may typically extend in horizontal direction (x-axis) and in vertical direction (z-axis), thus enabling to create an indication of radiation intensity 70 including an area of maximum radiation intensity 72. The indication of radiation intensity may be referred to as a sensor image. The image align sensor basically scans the projected image, to find a position wherein the photodetector gratings 66 are aligned with the reticle gratings 62. The image align sensor IS herein provides the sensor image 70. At the respective position of the object table where the respective gratings 62, 66 align, the areal image provides the maximum 72.

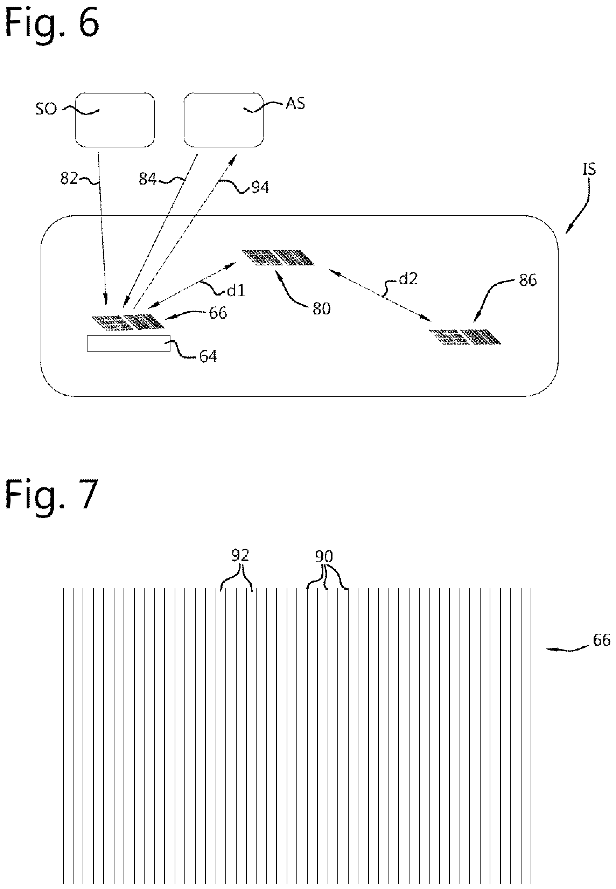

Generally referring to Figure 6, conventionally, a first sensor, for instance an image sensor IS, may comprise multiple gratings 66, 80, 82. The respective gratings are typically arranged at a mutual distance d1, d2. Said mutual distance is adamant, i.e. has a minimum distance, for instance due to physical constraints (as respective elements of a sensor at least require some space) or due to available production which may require the features to have some spacing in between as well.

For instance, the detector grating 66 may be regarded as a first grating. The first grating may be a grating intended as a marker for image alignment, as described above. The first grating 66 may be provided on top of the detector 64. A second grating 80 may be a marker for a second sensor different from the first sensor. The second sensor may be, for instance, the alignment sensor AS.

Herein, the detector 64 may be adapted to detect first radiation 82 as transmitted through the first grating 66. Said first radiation may typically originate from the source SO, as described above with respect to one of Figures 1 to 3. The first radiation 82 herein relates to a first sensor. In the example of Fig. 6, the first sensor is an Image Sensor IS.

The alignment sensor may typically use a second type of radiation to detect the respective second grating 80. Said second radiation 84 typically differs from the first radiation as used by the sensor 66. Herein, the first grating 66 is typically optimized for the first radiation 82, whereas the second grating 80 is optimized with respect to the second radiation 84. The second radiation 84 may originate from a second sensor. In the example of Fig. 6, the second sensor is the Alignment Sensor AS.

The sensor IS may include a third grating 86. The third grating or marker may be optimized for either one of the first or second types of radiation, or may be optimized for yet another, third type of radiation of a third sensor.

As an example, and as described above, the first radiation may be in the EUV spectrum. The second radiation may be in the visible light spectrum (for instance on the order of 400 to 700 nm), in the ultraviolet light spectrum, or in the infrared spectrum.

The present disclosure proposes to use the first grating 66 for multiple purposes. Said purposes may include, at least, as a marker for the second sensor. Said second sensor may be the alignment sensor AS. The alignment sensor may be intended for, but is not limited to, image alignment and object table alignment.

Generally referring to Figure 7, alignment marks or gratings 66, 80, 82 may include a series of first lines 90. In between the first lines are second lines 92. Herein, the first lines 90 may be substantially transmissive for the first radiation, while the second lines 92 may be substantially reflective or absorbing. Thus, EUV light impinging on the first grating will reach the first detector 64 only at the positions of the first lines 90. The first grating may be arranged on a respective carrier.

According to the invention, second radiation 84 originating from the second sensor is directed to the same, first grating 66. The incoming alignment sensor radiation, see second radiation 84 in Fig. 6, diffracts on the line pattern of the first grating 66. The reflected second radiation 94 can be detected by the second sensor.

The second sensor may optically process the reflected second radiation 94 to determine the position of the first grating, and use said position as a mark position for image alignment. In an embodiment, a reflected grating line pattern, i.e. the pattern of the first and second lines 90, 92 respectively as reflected towards the second sensor, may be created by moving the first grating 66 with respect to a respective detector of the second sensor. The latter enables to use the first grating for the second radiation without specifically optimizing said first grating for the second radiation.

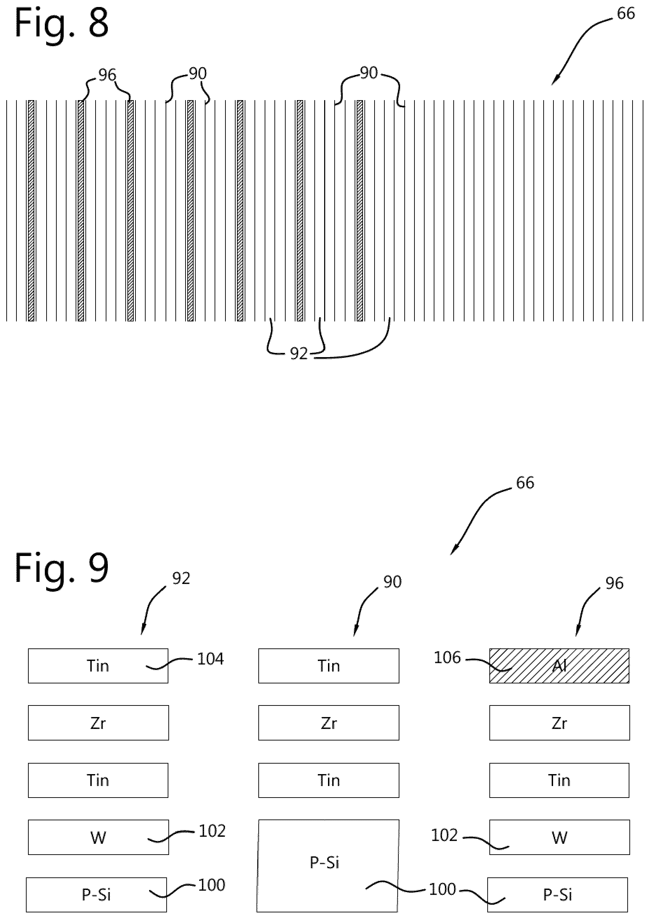

Generally referring to Figure 8, in an embodiment, one or more third lines 96 may be arranged in between the first lines 90 and the second lines 92. The third lines 96 may substantially reflect the second radiation 84. In conjunction, the third lines 96 may form a reflective pattern. Thus, the first grating 66 can be optimized both for the first radiation and the second radiation at the same time. Herein, the first lines 90 may be substantially transmissive for the first radiation, while the third lines 96 are substantially reflective for the second radiation.

Generally referring to Figure 9, in an embodiment, the first lines, the second lines and/or the third lines are typically comprised of a layered structure. For example, the first lines 90 may be transmissive for the first radiation, while the second lines 92 substantially absorb the first radiation.

Herein, a first layer 100 of the respective lines may be provided with a first radiation absorbing second layer 102, to optimize the grating pattern for the first radiation.

To optimize the pattern for the second radiation, one or more of the second lines may include a third layer 104. For some lines, said third layer may be replaced with a fourth layer 106 of another material. Herein, the material of the fourth layer may be substantially reflective for the second radiation, while the material of the third layer 104 is not.

In the examples and embodiments described above, the terms "transmissive", "reflective", "absorbing" etc. are all intended as relative terms. So, one material (or composition of materials) may transmit in the range of 50 to 80% of the first radiation, while another material may absorb in the range of 90 to 100% of the same radiation. The same holds for reflection. Whereas one material may reflect about 20 to 80% of the second radiation, another material may absorb in the range of 95 to 100% of the same radiation. Lines which are transmissive for one type of radiation, may in practice reflect at least part of another type of radiation. It is not full reflecting or absorbing, but in the end the contrast is what matters, the difference in reflectance and transmission between respective materials, or composition of materials.

In a practical embodiment, the first lines 90 comprise a stack of materials which are all substantially transmissive for EUV light. Said materials may include one or more of, but are not limited to, tin, zirconium, and p-doped silicon. The respective layers may have a thickness on the order of 5 to 100 nm.

The second lines may have a layered structure relatively similar to the first lines, while also including at least one layer which absorbs EUV light. Said absorbing layer may include one or more of tungsten, tungsten carbide, graphite, aluminum, chromium, ferro, nickel.

The third lines 96 may have a layered structure relatively similar to the second lines, wherein a top layer is comprised of a material which substantially reflects the second radiation. Said top layer may comprise one or more of, for instance, aluminum, silver, copper, gold.

As described above, the first grating 66, as optimized for EUV light and only comprising a line structure comprised of an optical stack design including the first lines 90 and the second lines 92, is already capable of providing a visible contrast signal when scanned with second radiation, for instance originating from the alignment sensor AS.

While the embodiment based on the conventional stacked structure is a viable baseline, if required the optical contrast can be enhanced by optimizing the stack with finely tuned optical coatings for create the third lines. Said third lines, for example, may include patterning of a Zr layer on top of a Tungsten absorber. The width can be chosen to be optimal for the signal as required by the second sensor.

In a practical embodiment, the geometry of the grating 66 may have a variable pitch. The second lines may have a line width in the range of 0.5 to 5 µm. The second lines 92 may have a linewidth on the order of 50 to 500 nm. The geometrical pattern can be changed to be compatible with alignment marks or interleaved lines can be used as exemplified in Figure 8.

In order to maximize the performance of the system and method as proposed herein, many modifications are conceivable, such as:
- Optimize the geometrical design of the respective lines of the grating pattern;
- Change the optical stack of respective lines to improve the optical contrast and optimize the reflected signal for the specific wavelength of the second radiation. See for instance Figure 9 in respect of added layers on top of the second lines 92 to tune the line width thereof for the second sensor independent of the area of the first lines 90 which is substantially open to the first radiation and thus for the transmissive image sensor IS.
- Possibly: use marks on the reticle (the mask) matching one of the patterns on the first grating 66.

Tests have indicated that even a 0.1% difference in reflectivity between the first lines 90 and the second lines 92 can create a detectable contrast. Said contrast is sufficient to use as a reflected signal for the second sensor.

To enhance the contrast, optical simulations were done on various potential die stacks. The simulations indicate that by making small modifications in the EUV blocking area (i.e. the second lines and the third lines) the contrast can be improved more than 300 times, without having to change the stack in the EUV sensitive area, i.e. the first lines 90.

The wavelength of the second radiation can be matched to the structure of the first grating, for instance by using interleaved lines, as exemplified in Figure 8. The alignment sensor observes the signal from the reflective third lines. Herein, the first sensor, or image sensor IS, uses the EUV transmissive first lines. The stack in the EUV transmissive lines can be kept the same, there is no signal penalty.

An additional benefit of having first markings 66 suitable for use with the second sensor, and vice versa, is that alignment marks on reticles can be used as image sensor reticle gratings and their signal can be detected using the image sensor IS. Thus, actions such as reticle align are viable at any spot on the reticle where an alignment mark, enabling higher order reticle shape corrections.

Although the embodiments herein above have been described with respect to EUV image markers, the same might hold for other marks, such as Yieldstar marks.

There are several benefits foreseeable from the proposed concept design:
As the location of the marker for image align measurements and stage align measurements will be exactly the same, problems arising from the existence of a shift between the image sensor detector position and alignment marks are intrinsically resolved. In particular, the proposed solution provides immunity for any image sensor plate deformation, in particular drift in the mutual distance between image sensor detector markers and alignment markers. Thus, any of the corresponding impacts on overlay error can be obviated.

If the grating of the image sensor detectors can be used as a marker for the alignment sensor, conversely it will be possible to match the two grating geometries. For instance, light from alignment marks on the reticle could be measured by the image sensor IS. This enables to measure, using the image sensor IS, at any of the reticle locations where a (compatible) alignment mark is located, rather than only at a limited number of locations outside the image field of the reticle, where conventional IS marks are. In this way, higher order reticle deformations can be measured directly, instead of only through resist.

Using IS detector gratings as alignment marks provides additional redundancy for the alignment function. Furthermore, even when independent alignment marks are still included on the sensor surface and used for their conventional scope, measuring with alignment sensor on the TIS detector allows for periodic monitoring and inline calibration and correction of, for example, their relative drift with respect to the alignment marks.

A varying IS detector grating pitch structure enables a self-referencing option for position readout matching when using the alignment.

It is worth noting that the visible light of the alignment sensor lasers can actually be detected by the IS photodiodes of the first detector 64. In principle, this can be used to further integrate the position measurement functionality, to improve the application range or the accuracy. For example, in case of an alignment mark with a varying duty cycle (for instance with a varying pitch), the alignment light measured with the image sensor IS can be used as a rough capture scan, where the different positions correspond to different amounts of intensities.

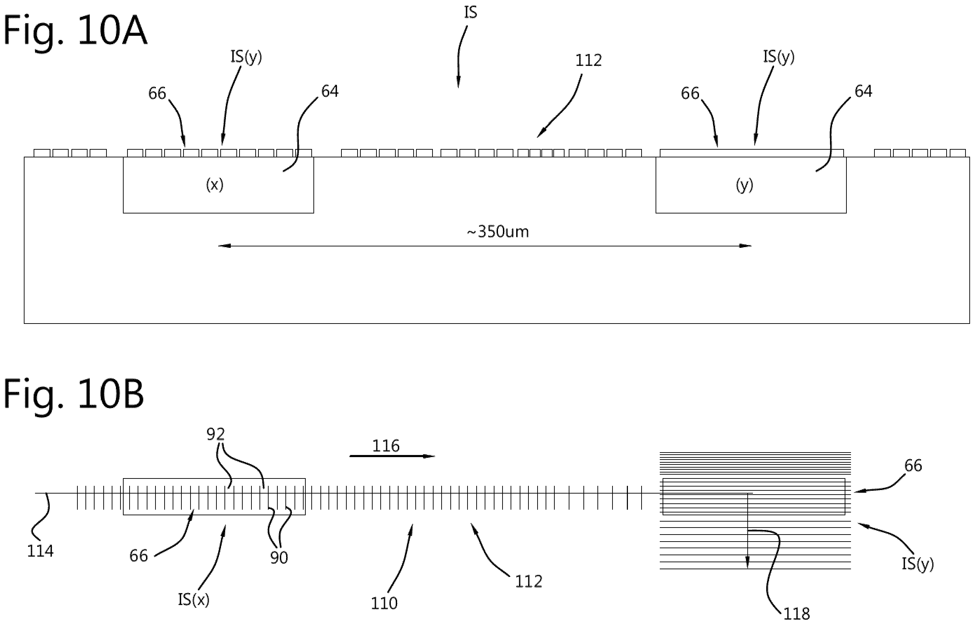

Referring to Figures 10A and 10B, a space between two respective IS detectors (for example, IS(x) and IS(y)) can be filled with alignment mark line structures 112. Thus, a single alignment scan move, indicated by arrows 114, 116, 118, all over the IS detector surface, from side to side and in multiple perpendicular directions, may be used.

Finally, scanning with the alignment sensor over the IS grating detectors 66 may enable diagnostics, such as:
Examine the status of the IS photodiodes by measuring the transmitted light detected by the IS electronics. For example, this may prove uniformity of electrical response over the detector, or presence of contaminants on the surface of the sensor IS obscuring the detectors 64;
Assess the intact quality of a functional coating on top of the IS detectors 64 via the alignment sensor signal. For instance, by inspecting for damages or scratches or contaminants over their surface.

When alternating the top layer for the transparent and non-transparent areas, typically comprised of the first lines 90 and the second lines 92 respectively, the following contrasts can be achieved:
With TiN capping layer: on the order of 35%;
Without a TiN capping layer: on the order of 50 to 55%.

Thus, by introducing small modifications in the EUV blocking area a significant (>300x) contrast improvement can be achieved without having to change the stack in the EUV sensitive area.

The ideal detector mark pitch and the alignment mark pitch may be different. For an EUV detector, lines on the order of 100 nm or smaller. On the other hand, alignment marks are on the order of 1 to 5 um. To overcome this difference, alignment marks can be applied on top of the stack, even without changing the EUV transmissive stack. This can be further extended by making alignment marks between IS gratings, see Figure 8.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrates) or mask (or other patterning devices). These apparatus may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

## Claims

1. A sensor system, comprising:
- a first sensor for determining a position of an aerial image as formed by a projection system, the first sensor comprising at least one first grating, and a detector configured to record first radiation transmitted through the first grating; and
- a second sensor for detecting second radiation as reflected from the at least one first grating.

2. The sensor system of claim 1, wherein the first grating is configured as a reference marker for the second sensor.

3. The sensor system of claim 2, wherein the second sensor is an alignment sensor.

4. The sensor system of one of the previous claims, wherein the first sensor is an image sensor.

5. The sensor system of one of the previous claims, wherein the at least one first grating comprises a first array of lines allowing at least part of the first radiation to pass through.

6. The sensor system of one of the previous claims, wherein the at least one first grating comprises a second array of lines configured to substantially absorb the first radiation, the second array of lines being interleaved with the first array of lines.

7. The sensor system of claim 5 or 6, comprising a third array of lines, configured to substantially reflect the second radiation towards the second sensor, the third array of lines being interleaved with the first array of lines.

8. The sensor system of claim 7, wherein the third array of lines comprises a top layer comprised of a material which is substantially reflective for the second radiation.

9. The sensor system of claim 8, wherein the material comprises one or more of aluminum, silver, copper, or gold.

10. The sensor system of one of the previous claims, wherein the first radiation is in the EUV spectrum.

11. The sensor system of one of the previous claims, wherein the second radiation includes radiation in one of more of the ultraviolet spectrum, the visible light spectrum, or the infrared spectrum.

12. An object stage, comprising a sensor system, the sensor system comprising: - a first sensor for determining a position of an aerial image as formed by a projection system, the first sensor comprising at least one first grating, and a detector configured to record first radiation transmitted through the first grating, the at least one first grating being adapted for reflecting second radiation towards a second sensor.

13. A lithographic apparatus comprising:
an object stage, comprising a sensor system, the sensor system comprising: - a first sensor for determining a position of an aerial image as formed by a projection system, the first sensor comprising at least one first grating, and a detector configured to record first radiation transmitted through the first grating, the at least one first grating being adapted for reflecting second radiation towards a second sensor.

14. The lithographic apparatus of claim 13, comprising a source of the second radiation.

15. The lithographic apparatus of claims 13 or 14, the sensor system comprising a third sensor, for detecting third radiation as reflected from the at least one first grating.

16. The lithographic apparatus of one of claims 13 to 15, comprising a source of the first radiation for exposure of a pattern on a substrate, the first radiation being in the extreme ultraviolet (EUV) spectrum.

17. Method of image alignment, the method comprising the steps of:
- projecting an aerial image onto a sensor system using first radiation;
- using a first sensor for determining a position of the aerial image, the first sensor comprising at least one first grating and a detector configured to record the first radiation as transmitted through the first grating;
- projecting second radiation onto the first grating; and
- using a second sensor for detecting the second radiation as reflected from the at least one first grating.

18. The method of claim 17, wherein the step of using the second sensor for detecting the second radiation as reflected from the at least one first grating includes alignment of an object with respect to a reference position.
